# EUROPEAN PATENT APPLICATION

(11) **EP 3 671 770 A1**
(43) Date of publication of application: **24.06.2020**
(21) Application number: 19217473.8
(22) Date of filing: 18.12.2019
(51) Int. Cl.: H01B 11/06

(54) **CABLE STRUCTURE AND MANUFACTURING METHOD THEREOF**

(30) Priority: 19.12.2018 TW 107145833
(71) Applicant: Wu, Cheng-Yi, Taoyuan City 335 (TW); Lien, Chen-Che, Taipei City 100 (TW)
(72) Inventor: Wu, Cheng-Yi, Taoyuan City 335 (TW); Lien, Chen-Che, Taipei City 100 (TW)
(74) Representative: Durán-Corretjer, S.L.P.

(57) **Abstract**

A cable structure (C) and a manufacturing method thereof are provided. The cable structure (C) includes a transmission component (1) and a protection component (2). The transmission component (1) includes at least one first intermedium unit (10), and the least one first intermedium unit (10) includes at least one first transmission cable (100) and a first barrier layer (101) covering the at least one first transmission cable (100). The protection component (2) includes at least one shielding layer (21) covering the at least one first intermedium unit (10) and an insulating layer (22) covering the at least one shielding layer (21). The at least one shielding layer (21) includes a metal foil layer (210) covering the at least one first intermedium unit (10) and at least one conducting layer (211) formed on a surface of the metal foil layer (210).

## Description

### CROSS-REFERENCE TO RELATED PATENT APPLICATION

This application claims the benefit of priority to Taiwan Patent Application No. 107145833, filed on December 19, 2018. The entire content of the above identified application is incorporated herein by reference.

Some references, which may include patents, patent applications and various publications, may be cited and discussed in the description of this disclosure. The citation and/or discussion of such references is provided merely to clarify the description of the present disclosure and is not an admission that any such reference is "prior art" to the disclosure described herein. All references cited and discussed in this specification are incorporated herein by reference in their entireties and to the same extent as if each reference was individually incorporated by reference.

### FIELD OF THE DISCLOSURE

The present disclosure relates to a cable structure and a manufacturing method thereof, and more particularly to a cable structure that possesses an electromagnetic interference (EMI) shielding function without metal braid structure and a manufacturing method of the cable structure.

### BACKGROUND OF THE DISCLOSURE

Electromagnetic interference (EMI) has been an issue to be solved in the high frequency electronic cable communication transmission system. Conventional methods for absorbing radiation wave is to weave (i.e., forming a cable mesh structure) a metal braid by aluminum foils, copper cables, aluminum cables or a combination of other metal alloy so as to achieve an effect of shielding EMI. However, since higher speed transmission standard and interfaces (e.g., a transmission speed of HDMI 1.3 standard could reach 10.2 Gbps) are popularly used, higher EMI is incurred when the transmission cables are transmitting high frequency signals. Accordingly, a weaving number of the metal braid should be increased to effectively shield the EMI. As a result of increasing the weaving number of the metal braid, a weight of the electronic cable is increased, and a flexibility of the electronic cable is reduced, so that it is difficult to complete the metal braid. Furthermore, even though the weaving number of the metal braid is high, there are still gaps formed between the cable mesh structure of the metal braid, which diminishes the effect of shielding the EMI and thereby lowering quality of signal transmission.

### SUMMARY OF THE DISCLOSURE

In response to the above-referenced technical inadequacies, the present disclosure provides a cable structure and a manufacturing method thereof.

In one aspect, the present disclosure provides a cable structure. The cable structure includes a transmission component and a protection component. The transmission component includes at least one first intermedium unit. The at least one first intermedium unit includes at least one first transmission cable and a first barrier layer that covers the at least one first transmission cable. The protection component includes at least one shielding layer that covers the at least one first intermedium unit and an insulating layer that covers the at least one shielding layer. The at least one shielding layer includes a metal foil layer covering the at least one first intermedium unit and at least one conducting layer formed on a surface of the metal foil layer.

In certain embodiments, the present disclosure provides a cable structure, wherein the at least one conducting layer includes one of the following: a first conducting material, a second conducting material, a third conducting material, and the combination of at least two of the first, second, and third conducting materials.

In one aspect, the present disclosure provides a manufacturing method of a cable structure. The manufacturing method includes the steps of: providing a transmission component that includes at least one first intermedium unit, the at least one first intermedium unit including at least one first transmission cable and a first barrier layer that covers the at least one first transmission cable; covering the transmission component by at least one shielding layer; and covering the at least one shielding layer by an insulating layer. The at least one shielding layer includes a metal foil layer that covers the transmission component and at least one conducting layer formed on a surface of the metal foil layer.

In certain embodiments, the present disclosure provides a manufacturing method of the cable structure, wherein the at least one conducting layer includes one of the following: a first conducting material, a second conducting material, a third conducting material, and the combination of at least two of the first, second, and third conducting materials.

Therefore, by virtue of "the protection component includes at least one shielding layer that covers the at least one first intermedium unit and an insulating layer that covers the at least one shielding layer" and "the at least one shielding layer includes the metal foil layer covering the at least one first intermedium unit and at least one conducting layer formed on the surface of the metal foil layer" of the cable structure and the manufacturing method of the cable structure provided by the present disclosure, the effect of shielding EMI can be substantially increased without metal braid structure.

These and other aspects of the present disclosure will become apparent from the following description of the embodiment taken in conjunction with the following drawings and their captions, although variations and modifications therein may be affected without departing from the spirit and scope of the novel concepts of the disclosure.

### BRIEF DESCRIPTION OF THE DRAWINGS

The present disclosure will become more fully understood from the following detailed description and accompanying drawings.
FIG. 1 is a first cross-sectional view of a cable structure according to a first embodiment of the present disclosure.
FIG. 2 is an enlarged schematic view of portion II of FIG. 1.
FIG. 3 is a second cross-sectional view of the cable structure according to the first embodiment of the present disclosure.
FIG. 4 is a cross-sectional view of the cable structure according to a second embodiment of the present disclosure.
FIG. 5 is a cross-sectional view of the cable structure according to a third embodiment of the present disclosure.
FIG. 6 is a cross-sectional view of the cable structure according to a fourth embodiment of the present disclosure.
FIG. 7 is a flow chart of a manufacturing method of the cable structure according to the present disclosure.
FIG. 8 is a flow chart of a manufacturing method of a conducting layer according to the present disclosure.
FIG. 9 is a flow chart of a processing method of the conducting layer according to the present disclosure.

### DETAILED DESCRIPTION OF THE EXEMPLARY EMBODIMENTS

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the meaning of "in" includes "in" and "on". Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

### [First Embodiment]

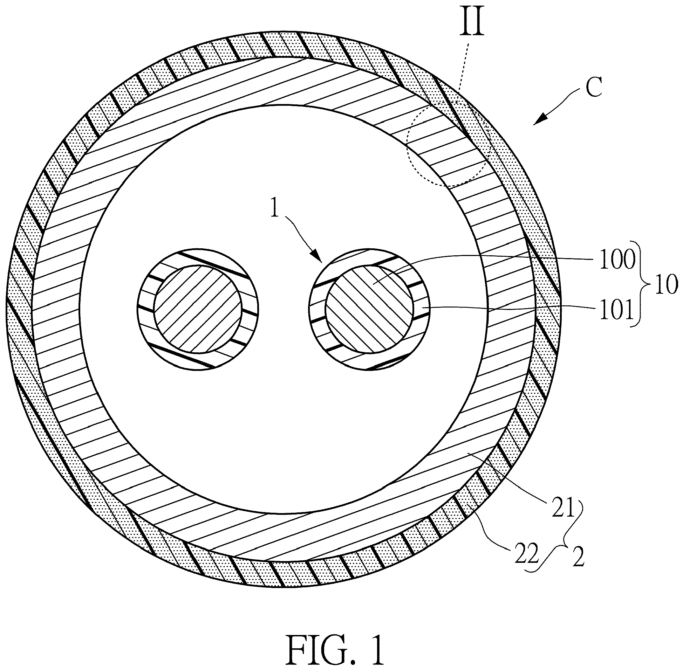

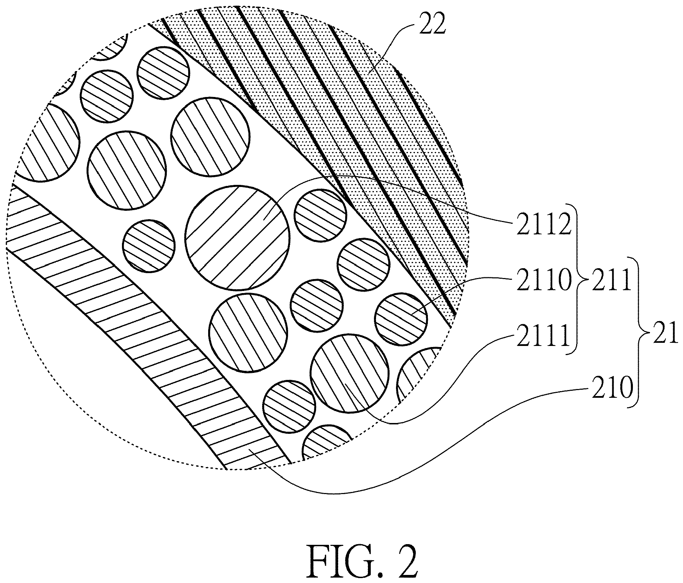

Referring to FIG. 1 to FIG. 3, a first cross-sectional view of a cable structure according to a first embodiment of the present disclosure, an enlarged schematic view of portion II of FIG. 1, and a second cross-sectional view of the cable structure according to the first embodiment of the present disclosure are shown, respectively. As shown in the drawings, the first embodiment of the present disclosure provides a cable structure C. The cable structure C includes a transmission component 1 and a protection component 2. The transmission component 1 includes at least one first intermedium unit 10. The at least one first intermedium unit 10 includes at least one first transmission cable 100 and a first barrier layer 101 that covers the at least one first transmission cable 100. The protection component 2 includes at least one shielding layer 21 that covers the at least one first intermedium unit 10 and an insulating layer 22 that covers the at least one shielding layer 21. The at least one shielding layer 21 includes a metal foil layer 210 covering the at least one first intermedium unit 10 and at least one conducting layer 211 formed on a surface of the metal foil layer 210.

Specifically, the first embodiment of the present disclosure provides the cable structure C that includes the transmission component 1 and the protection component 2. The transmission component 1 further includes at least one first intermedium unit 10. The at least one first intermedium unit 10 includes at least one first transmission cable 100 and the first barrier layer 101. The first transmission cable 100 can be regarded as a signal transmission cable. The first barrier layer 101 can be formed of insulating materials, but not limited thereto. The first barrier layer 101 covers the first transmission cable 100.

The protection component 2 further includes at least one shielding layer 21 and the insulating layer 22. The insulating layer 22 can be formed of insulating materials, but not limited thereto. The at least one shielding layer 21 can include the metal foil layer 210 and at least one conducting layer 211. The metal foil layer 210 can be made of copper foil materials, aluminum foil material or other conducting materials, but not limited thereto. The at least one conducting layer 211 can be made of conducting materials, and can be formed by coating on a surface of the metal foil layer 210 opposite to the first intermedium unit 10, but not limited thereto. The at least one shielding layer 21 covers the at least one first intermedium unit 10, and the insulating layer 22 covers the at least one shielding layer 21.

Therefore, when the at least one first intermedium unit 10 transmits high frequency signals, the at least one conducting layer 211 between the metal foil layer 210 and the insulating layer 22 can shield and absorb EMI transmitted from outside, so as to stabilize signal transmission quality of the cable structure C.

By virtue of the at least one conducting layer 211 that is disposed between the metal foil layer 210 and the insulating layer 22 for shielding and absorbing EMI transmitted from outside, a configuration of a conventional metal braid can be omitted. As a result, the weight of the electronic cable is reduced and flexibility of the electronic cable is increased. Moreover, since the at least one conducting layer 211 is formed by coating on the surface of the metal foil layer 210, there is no gap formed on a range of shielding EMI. Therefore, the electronic cable of the present disclosure possesses better masking capability than the conventional electronic cable.

Moreover, the at least one conducting layer 211 can include one of the following: a first conducting material 2110, a second conducting material 2111, a third conducting material 2112, and the combination of at least two of the first, second, and third conducting materials 2110, 2111, 2112. Furthermore, the first conducting material 2110 can be graphene, the second conducting material 2111 can be graphite, graphite carbon pipe, or a combination thereof, and the third conducting material 2112 is at least one of gold, silver, copper, iron, aluminum and nickel, but not limited thereto.

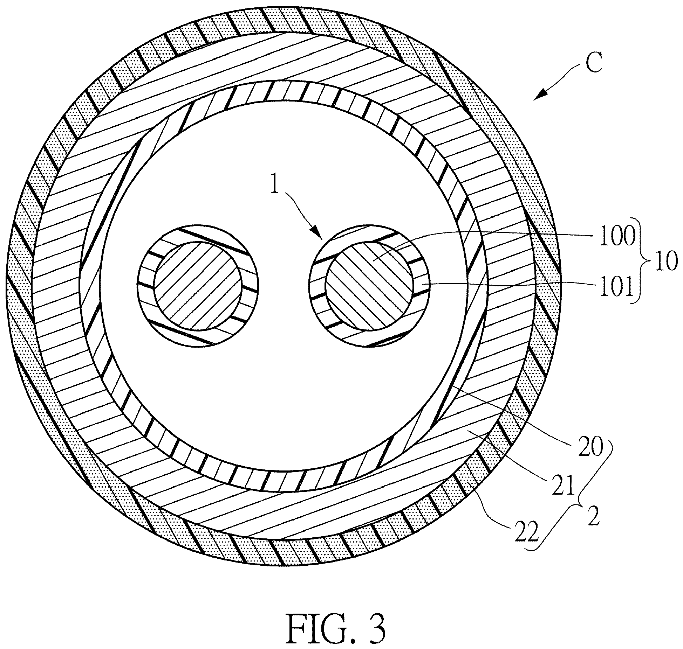

Referring to FIG. 3, in one of the embodiments, the protection component 2 can further include an isolating layer 20 that is made of insulating materials, but not limited thereto. The isolating layer 20 covers the at least one first intermedium unit 10; the at least one shielding layer 21 covers the isolating layer 20; the insulating layer 22 covers the at least one shielding layer 21.

### [Second Embodiment]

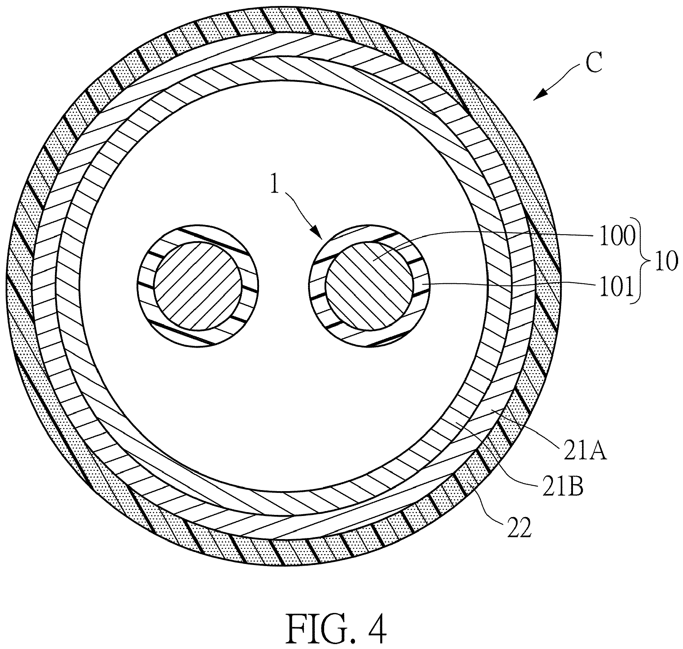

Referring to FIG. 4, a cross-sectional view of the cable structure according to a second embodiment of the present disclosure is shown. Further referring to FIG. 1 to FIG. 3, the cable structure of this embodiment is similar to the first embodiment, and the detailed descriptions of the same components in these embodiments are thus be omitted hereinafter for sake of brevity. It should be noted that, the protection component 2 in this embodiment further includes a plurality of shielding layers 21A, 21B, which can be stacked layer-upon-layer between the at least one first intermedium unit 10 and the insulating layer 22.

For example, in order to improve the effect of shielding and/or absorbing EMI from outside of the cable structure of the present disclosure, the plurality of shielding layers 21A, 21B can be configured. For instance, two shielding layers are configured in this embodiment, but not limited thereto. In other words, the protection component 2 can further include multiple shielding layers 21A, 21B which are stacked layer-upon-layer between the at least one first intermedium unit 10 and the insulating layer 22. Moreover, the material of the conducting layer 211 of the shielding layer 21A can be exactly the same or partially the same as that of the conducting layer 211 of the shielding layer 21B. Consequently, by configuration of the layer-upon-layer stacking of the shielding layer 21A and the shielding layer 21B, the effect of shielding EMI from outside can be substantially increased.

The shielding layer 21A can also be formed, by coating, on a surface of the shielding layer 21B, but not limited thereto.

### [Third Embodiment]

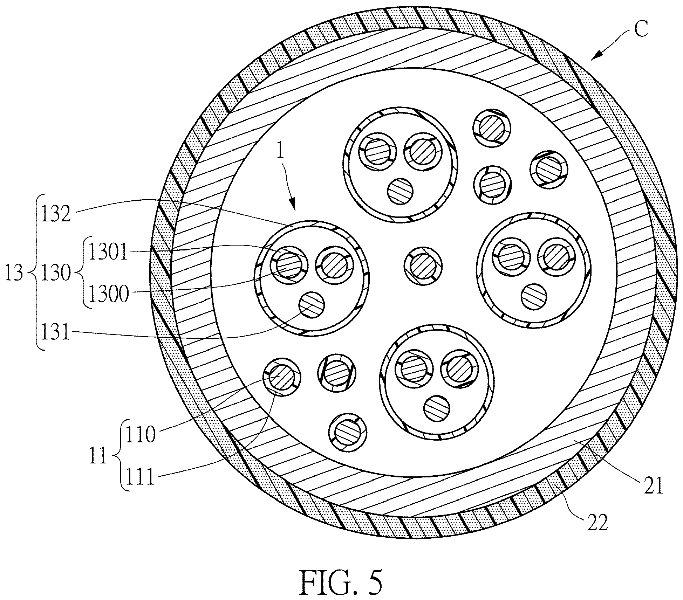

Referring to FIG. 5, a cross-sectional view of the cable structure according to the third embodiment of the present disclosure is shown. Further referring to FIG. 1 to FIG. 4, the cable structure of this embodiment is similar to the aforesaid embodiments, and the detailed descriptions of the same components in these embodiments are thus be omitted hereinafter for sake of brevity. It should be noted that, the transmission component 1 in this embodiment further includes at least one third intermedium units 13. The at least one third intermedium units 13 includes a plurality of conducting cables 130, a third transmission cable 131, and a third barrier layer 132 that covers the plurality of conducting cables 130 and the fourth transmission cable 131. Each of the conducting cables 130 includes a cable core 1300 and an insulating layer 1301.

For example, the transmission component 1 of the cable structure C of the present disclosure can further include the plurality of first intermedium units 10 and the plurality of third intermedium units 13. Each of the cable core 1300, the third transmission cable 131 and the first intermedium units 10 can be signal transmission cables. Each of the third barrier layer 132, the insulating layer 1301 and the first barrier layer 101 can be made of insulating materials. Therefore, the at least one shielding layer 21 of the cable structure C of the present disclosure covers the plurality of first intermedium units 10 and the plurality of third intermedium units 13. The insulating layer 22 covers the shielding layer 21.

### [Fourth Embodiment]

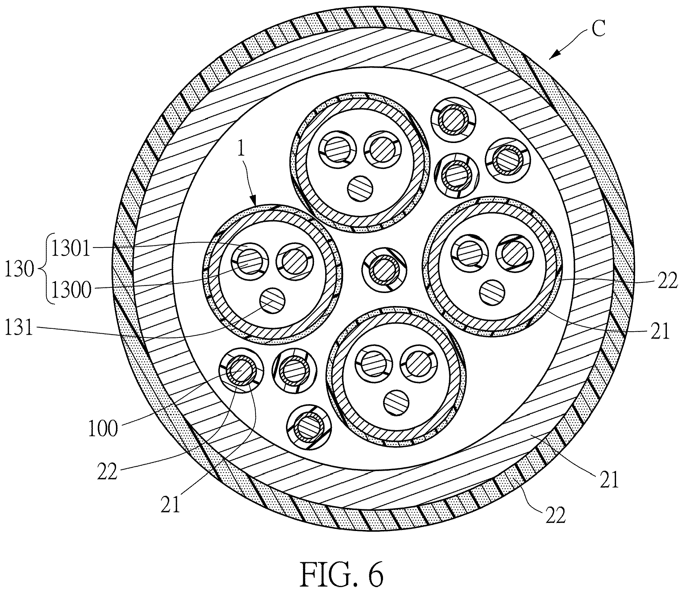

Referring to FIG. 6, a cross-sectional view of the cable structure according to a fourth embodiment of the present disclosure is shown. Further referring to FIG. 1 to FIG. 5, the cable structure of this embodiment is similar to the aforesaid embodiments, and the detailed descriptions of the same components in these embodiments are thus be omitted hereinafter for sake of brevity. It should be noted that the cable structure in this embodiment is similar to that in the third embodiment, and the only difference resides in that the third barrier layer 132 and the first barrier layer 101 are replaced by the shielding layer 21 and the insulating layer 22 in this embodiment so as to improve the effect of shielding EMI.

In addition to demonstrating the cable structure C of the present disclosure in abovementioned embodiments, a manufacturing method of the cable structure C will be further illustrated as follows for better understanding.

### [Manufacturing Method of cable Structure]

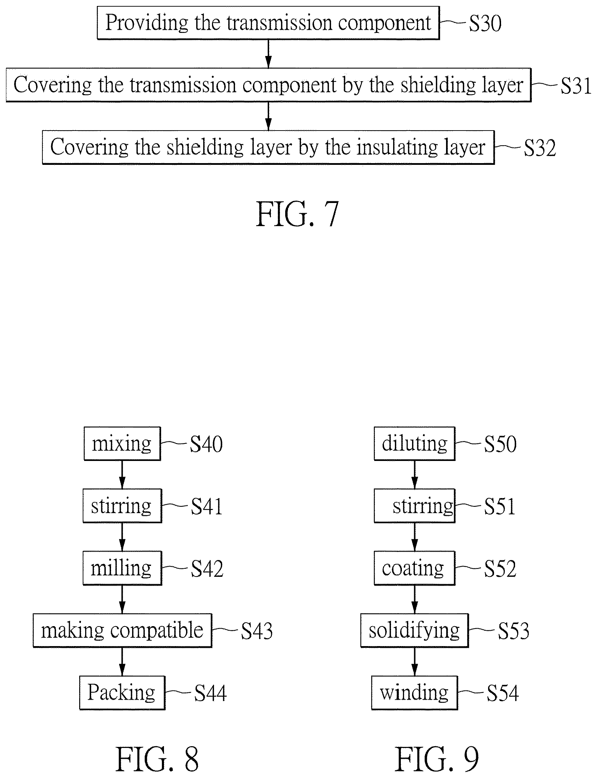

Referring to FIG. 7 to FIG. 9, a flow chart of a manufacturing method of the cable structure according to the present disclosure, a flow chart of a manufacturing method of a conducting layer according to the present disclosure, a flow chart of a processing method of the conducting layer according to the present disclosure are shown, respectively. Further referring to FIG. 1 to FIG. 6, the manufacturing method of the cable structure C includes the following steps.

The first step is to provide a transmission component. The transmission component can include at least one first intermedium unit. The at least one first intermedium unit includes at least one first transmission cable and a first barrier layer that covers the at least one first transmission cable (Step S30).

The next step is to cover the transmission component by at least one shielding layer (Step S31).

And then, the next step is to cover the at least one shielding layer by an insulating layer (Step S32).

Further, referring to FIG. 8, the present disclosure provides a manufacturing method of the conducting layer. The manufacturing method includes the following steps.

The first step is to proportionately mix first conducting materials 2110, second conducting materials 2111, third conducting materials 2112, or a combination thereof (Step S40).

Then, the next step is to stir the mixed materials (Step S41).

Further, the next step is to mill the stirred materials (Step S42) so as to homogenize and minimize compositions of the materials.

After that, steps of grinding, extending, rolling, and stretching on the materials are repeatedly applied until the materials are fully mixed and compatible (Step S43). In process of mixing the materials, particular solvent and/or auxiliaries can be added while stirring the materials such that the materials can be completely mixed and compatible. The aforesaid particular solvent and auxiliaries are conventional materials thus the detailed descriptions thereof are omitted herein.

Finally, the last step is to seal or pack the compatible materials (Step S44).

Furthermore, referring to FIG. 9, the present disclosure provides a processing method of the conducting layer. The processing method includes the following steps.

The first step is to dilute, by particular diluent, the sealed or packed materials for obtaining material liquid (Step S50).

Then, the next step is to stir the dilute material liquid for adjusting stickiness of the material liquid (Step S51).

Further, the next step is to evenly coating the adjusted material liquid on the metal foil layer 210 (Step S52).

After that, the next step is to solidify the material liquid on the metal foil layer 210 so as to form the conducting layer 211 (Step S53), wherein a degree of solidification is smaller or equal to 90 degree.

Finally, the last step is to obtain the shielding layer 21 and apply the winding process (Step S54).

As mentioned above, a workable thickness of the conducting layer 211 ranges between 10 um to 12 um and a material resistivity thereof ranges from 10² to 10⁵.

In conclusion, by virtue of "the protection component 2 includes at least one shielding layer 21 that covers the at least one first intermedium unit 10 and an insulating layer 22 that covers the at least one shielding layer 21" and "the at least one shielding layer 21 includes the metal foil layer 210 covering the at least one first intermedium unit 10 and at least one conducting layer 211 formed on the surface of the metal foil layer 210" of the cable structure C and the manufacturing method of the cable structure provided by the present disclosure, the effect of shielding EMI can be substantially increased.

Moreover, conventional methods for absorbing radiation wave is to weave (i.e., forming a cable mesh structure) a metal braid by aluminum foils, copper cables, aluminum cables or combination of other metal alloy so as to achieve effect of shielding EMI. While the weaving number of the metal braid is increased, a weight of the electronic cable is increased, and a flexibility of the electronic cable is reduced so that it is difficult to complete the metal braid. Furthermore, even though the weaving number of the metal braid is high, there are still gaps formed between the cable mesh structure of the metal braid, which diminishes effect of shielding the EMI and thereby lowering quality of signal transmission. Therefore, by virtue of the conducting layer 211 that is disposed between the transmission component 1 and the insulating layer 22 for shielding and absorbing EMI transmitted from outside, a configuration of a conventional metal braid can be omitted. Moreover, since the at least one conducting layer 211 is formed by coating on the surface of the metal foil layer 210, there is no gap formed on a range of shielding EMI. Therefore, the electronic cable of the present disclosure possesses better masking capability than the conventional electronic cable. Furthermore, the weight of the electronic cable is reduced and flexibility of the electronic cable is increased.

Further, the graphene metal foil (herein referred to as GMF; that is the shielding layer 21, and shielding layer 21 can be a graphene composite metal foil) manufactured by the cable structure and manufacturing method thereof of the present disclosure has reliable and excellent electromagnetic wave shielding ability of the new shielding material graphene metal foil manufactured by the above technical solution. GMF can replace the existing data cable configuration practice, eliminating metal foil and metal braided. By adopting GMF, processing procedure of the data cable can be changed and reduced, so that the new structured cable has characteristics of flexibility, weight reduction, and volume reduction.

The material of graphene metal foil (GMF) is based on graphite / graphene and mixed with conductive metal materials of different proportions. By using the manufacturing process of the cable structure and the conductive layer manufacturing method provided by the present disclosure, the surface of the metal foil is coated with "one or more layers of the same or different conductivity" materials. GMF materials are based on graphite / graphene, and conductive metal materials with different proportions are mixed on the surface of the metal foil to form a conductive layer. The shielding layer 21 (that is, "graphene metal foil") of the present disclosure is produced by coating processing on the surface of the metal foil. The surface of the conductive layer of the graphene metal foil is a conductive layer made of "having one or more layers of the same or different conductivity materials". The new structure combined with metal foil via the conductive layer has a shielding function for external electromagnetic waves and noise, achieving the effects of reflection, absorption and dissipation. The cable structure C and the graphene metal foil manufactured by the manufactured method thereof can replace the existing shielding material of the combination of metal foil and woven mesh, and process into the existing cable production process without any modification or purchase of any equipment. Adopting the graphene metal foil for cable manufacturing production not only increases the production volume, but also increases production efficiency.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from its spirit and scope.

## Claims

1. A cable structure (C), comprising:
a transmission component (1) including at least one first intermedium unit (10), the at least one first intermedium unit (10) including at least one first transmission cable (100) and a first barrier layer (101) that covers the at least one first transmission cable (100); and
a protection component (2) including at least one shielding layer (21) that covers the at least one first intermedium unit (10) and an insulating layer (22) that covers the at least one shielding layer (21);
wherein the at least one shielding layer (21) includes a metal foil layer (210) covering the at least one first intermedium unit (10) and at least one conducting layer (211) formed on a surface of the metal foil layer (210).

2. The cable structure (C) according to claim 1, wherein the at least one conducting layer (211) includes one of the following: a first conducting material (2110), a second conducting material (2111), a third conducting material (2112), and a combination of at least two of the first, second, and third conducting materials.

3. The cable structure (C) according to claim 1, wherein the first conducting material (2110) is graphene, the second conducting material (2111) is graphite, a graphite carbon pipe, or a combination thereof, the third conducting material (2112) is at least one of gold, silver, copper, iron, aluminum and nickel.

4. The cable structure (C) according to claim 1, wherein the transmission component (1) further includes at least one second intermedium unit (11), the at least one second intermedium unit (11) including at least one second transmission cable (110) and a second barrier layer (111), and the at least one shielding layer (21) covers the at least one second intermedium unit (11).

5. A manufacturing method of a cable structure (C), comprising:
providing a transmission component (1) that includes at least one first intermedium unit (10), the at least one first intermedium unit (10) including at least one first transmission cable (100) and a first barrier layer (101) that covers the at least one first transmission cable (100);
covering the transmission component (1) by at least one shielding layer (21); and
covering the at least one shielding layer (21) by an insulating layer (22);
wherein the at least one shielding layer (21) includes a metal foil layer (210) that covers the transmission component (1) and at least one conducting layer (211) formed on a surface of the metal foil layer (210).

6. The manufacturing method of the cable structure (C) according to claim 5, wherein the at least one conducting layer (211) includes one of the following: a first conducting material (2110), a second conducting material (2111), a third conducting material (2112), and the combination of at least two of the first, second, and third conducting materials.

7. The manufacturing method of the cable structure (C) according to claim 6, wherein the first conducting material (2110) is graphene, the second conducting material (2111) is graphite, graphite carbon pipe, or a combination thereof, the third conducting material (2112) is at least one of gold, silver, copper, iron, aluminum and nickel.

8. The manufacturing method of the cable structure (C) according to claim 5, wherein the transmission component (1) further includes at least one second intermedium unit (11), the at least one second intermedium unit (11) including at least one second transmission cable (110) and a second barrier layer (111), and the at least one shielding layer (21) covers the at least one second intermedium unit (11).
